# EUROPÄISCHE PATENTANMELDUNG

(11) **EP 4 657 517 A1**
(43) Veröffentlichungstag der Anmeldung: **03.12.2025**
(21) Anmeldenummer: 24178855.3
(22) Anmeldetag: 29.05.2024
(51) Int. Cl.: H01L 23/367, H01L 23/373, H01L 23/36, H01L 25/07

(54) **LEISTUNGSHALBLEITERANORDNUNG MIT EINEM LEISTUNGSHALBLEITERELEMENT UND EINEM SUBSTRAT**

(71) Anmelder: Siemens Aktiengesellschaft, 80333 München (DE)
(72) Erfinder: Kürten, Bernd, 90587 Obermichelbach (DE); Menz, Thomas, 91094 Langensendelbach (DE); Richter, Nico, 91083 Baiersdorf Hagenau (DE); Zeyß, Felix, 91052 Erlangen (DE)
(74) Vertreter: Siemens Patent Attorneys

(57) **Zusammenfassung**

Die Erfindung betrifft ein Leistungshalbleiteranordnung (2) aufweisend zumindest ein Leistungshalbleiterelement (4), ein Substrat (6) aufweisend eine dielektrische Materiallage (8) mit einer ersten Oberfläche (10) und einer zweiten Oberfläche (12), welche auf einer der ersten Oberfläche (10) abgewandten Seite der dielektrischen Materiallage (8) angeordnet ist, eine leitfähige Struktur (14), welche auf der ersten Oberfläche (10) der dielektrische Materiallage (8) ausgebildet ist und auf welcher das zumindest eine Leistungshalbleiterelement (4) kontaktiert ist, und eine Metalllage (16), welche auf der zweiten Oberfläche (12) der dielektrische Materiallage (8) angeordnet ist. Um die Performance und Zuverlässigkeit einer Leistungshalbleiteranordnung zu verbessern, wird vorgeschlagen, dass die Metalllage (16) zumindest eine Ausnehmung (22) und/oder zumindest eine nicht lötfähige Beschichtung (40) aufweist, welche in einer Draufsicht außerhalb einer Kontaktierungsfläche (20) des zumindest einen Leistungshalbleiterelements (4) angeordnet ist.

## Beschreibung

Die Erfindung betrifft eine Leistungshalbleiteranordnung aufweisend zumindest ein Leistungshalbleiterelement, ein Substrat aufweisend eine dielektrische Materiallage mit einer ersten Oberfläche und einer zweiten Oberfläche, welche auf einer der ersten Oberfläche abgewandten Seite der dielektrischen Materiallage angeordnet ist, eine leitfähige Struktur, welche auf der ersten Oberfläche der dielektrische Materiallage ausgebildet ist und auf welcher das zumindest eine Leistungshalbleiterelement kontaktiert ist, und eine Metalllage, welche auf der zweiten Oberfläche der dielektrische Materiallage angeordnet ist.

Ferner betrifft die Erfindung einen Stromrichter mit mindestens einer derartigen Leistungshalbleiteranordnung.

Überdies betrifft die Erfindung ein Verfahren zur Herstellung einer Leistungshalbleiteranordnung mit einem Substrat aufweisend eine dielektrische Materiallage mit einer ersten Oberfläche und einer zweiten Oberfläche, welche auf einer der ersten Oberfläche abgewandten Seite der dielektrischen Materiallage angeordnet ist, wobei eine leitfähige Struktur auf der ersten Oberfläche der dielektrischen Materiallage ausgebildet ist, wobei eine Metalllage auf der zweiten Oberfläche der dielektrischen Materiallage angeordnet ist.

Darüber hinaus betrifft die Erfindung ein Computerprogrammprodukt, umfassend Befehle, die bei einer Ausführung des Programms durch einen Computer diesen veranlassen, ein Verhalten einer derartigen Leistungshalbleiteranordnung zu simulieren.

Eine derartige Leistungshalbleiteranordnung kommt beispielsweise in einem Leistungsmodul in einem Stromrichter zum Einsatz. Unter einem Stromrichter ist beispielsweise ein Gleichrichter, ein Wechselrichter, ein Umrichter oder ein Gleichspannungswandler zu verstehen. In einer derartigen Leistungshalbleiteranordnung zum Einsatz kommende Leistungshalbleiterelemente können unter anderem Transistoren, Triacs, Thyristoren oder Dioden sein. Derartige Transistoren können unter anderem als Insulated-Gate-Bipolar-Transistoren (IGBTs) oder als Wide-Bandgap-Transistoren ausgeführt sein. Die Wide-Bandgap-Transistoren können beispielsweise in Siliziumcarbid- oder Galliumnitrid-Technologie realisiert sein und ermöglichen unter anderem höhere Schaltfrequenzen.

Die Offenlegungsschrift EP 3 958 306 A1 beschreibt ein Leistungsmodul mit mindestens zwei auf einem Substrat kontaktierten Leistungshalbleiteranordnungen, welche in einem Gehäuse angeordnet sind.

In einem derartigen Leistungsmodul sind ein oder mehrere Substrate, welche in der Regel eine keramische Materiallage mit beidseitiger Metallisierung aufweisen, stoffschlüssig mit einer Bodenplatte verbunden. Die stoffschlüssige Verbindung wird üblicherweise durch eine Lötverbindung hergestellt. Die Herstellung der stoffschlüssigen Verbindung durch Löten wird Systemlötung genannt. Durch die unterschiedlichen Materialien mit verschiedenen thermischen Ausdehnungskoeffizienten entsteht im Substrat ein Bimetall-Effekt, der zu einer Wölbung des Substrats bei Temperaturänderungen führt. Im betrachteten Fall des Lötens werden die beteiligten Materialien (Bodenplatte, Lot, Leistungssubstrat) bis zum Schmelzpunkt des Lots aufgeheizt. Dabei wölbt sich das Leistungssubstrat in der Regel so, dass es der Kontur der Bodenplatte, welche vorgewölbt ist, folgt. Beim Abkühlen am Ende des Lötvorgangs geht die Wölbung des Leistungssubstrats wieder nahezu in den Ausgangszustand zurück. Da die Bodenplatte aus nur einem Material besteht, ist die temperaturbedingte Änderung der Durchbiegung an diesem Teil nur gering vorhanden. Durch den Unterschied im Wölbungsverhalten kann sich beim Abkühlen lokal ein Abstand zwischen Bodenplatte und Substrat vergrößern.

Da das Lot im Randbereich des Substrats zuerst abkühlt und erstarrt, kann sich eine umlaufende feste Barriere ausbilden, während sich im inneren Bereich der Lötfläche unter dem Substrat noch flüssiges Lot befindet. In Kombination mit dem oben beschriebenen thermo-mechanischen Verhalten des Substrats kann im inneren Bereich der Lötfläche unter dem Substrat während der Abkühlphase ein Unterdruck entstehen. Aufgrund des Unterdrucks, kann es an einer Stelle, an der das bereits erstarrte Lot dünn ist, lokal zu einem Durchbruch kommen und es kann sich ein von der Durchbruchstelle ausgehender Hohlraum, ein sog. "Lunker", ausbilden. In diesem Bereich eines derartigen Hohlraums besteht keine durchgehende stoffschlüssige Verbindung zwischen dem Leistungssubstrat und der Bodenplatte, wodurch sich lokal der Wärmetransport von Leistungshalbleiter zu Bodenplatte verringert. Dies hat, insbesondere wenn der Hohlraum zumindest teilweise unter einem Leistungshalbleiter liegt, eine verringerte Performance zur Folge und/oder wirkt sich negativ auf die Lebensdauer der Leistungshalbleiteranordnung aus.

Vor diesem Hintergrund ist es eine Aufgabe der vorliegenden Erfindung, die Performance und Zuverlässigkeit einer Leistungshalbleiteranordnung zu verbessern.

Diese Aufgabe wird erfindungsgemäß durch eine Leistungshalbleiteranordnung der eingangs genannten Art dadurch gelöst, dass die Metalllage zumindest eine Ausnehmung und/oder zumindest eine nicht lötfähige Beschichtung aufweist, welche in einer Draufsicht außerhalb einer Kontaktierungsfläche des zumindest einen Leistungshalbleiterelements angeordnet ist.

Ferner wird die Aufgabe erfindungsgemäß durch eine Leistungshalbleiteranordnung der eingangs genannten Art dadurch gelöst, dass die Metalllage des Substrats über eine Lötverbindungsschicht flächig mit einer metallischen Oberfläche einer Wärmesenke verbunden ist, wobei die metallische Oberfläche der Wärmesenke zumindest eine nicht lötfähige Beschichtung aufweist, welche in einer Draufsicht außerhalb einer Kontaktierungsfläche des zumindest einen Leistungshalbleiterelements angeordnet ist.

Ferner wird die Aufgabe erfindungsgemäß durch ein Verfahren der eingangs genannten Art gelöst durch folgende Schritte: Einbringen zumindest einer Ausnehmung in die Metalllage, Kontaktieren eines Leistungshalbleiterelements auf der leitfähigen Struktur, flächiges Verbinden der Metalllage des Substrats über eine Lötverbindungsschicht mit einer metallischen Oberfläche einer Wärmesenke, wobei die Ausnehmung in einer Draufsicht außerhalb der Kontaktierungsfläche des zumindest einen Leistungshalbleiterelements angeordnet wird.

Ferner wird die Aufgabe erfindungsgemäß durch ein Verfahren der eingangs genannten Art gelöst durch folgende Schritte: Aufbringen zumindest einer nicht lötfähigen Beschichtung auf die Metalllage, Kontaktieren eines Leistungshalbleiterelements auf der leitfähigen Struktur, flächiges Verbinden der Metalllage des Substrats über eine Lötverbindungsschicht mit einer metallischen Oberfläche einer Wärmesenke, wobei die nicht lötfähigen Beschichtung in einer Draufsicht außerhalb der Kontaktierungsfläche des zumindest einen Leistungshalbleiterelements aufgebracht wird.

Ferner wird die Aufgabe erfindungsgemäß durch ein Verfahren der eingangs genannten Art gelöst durch folgende Schritte: aufweisend folgende Schritte: Aufbringen zumindest einer nicht lötfähigen Beschichtung auf eine metallische Oberfläche einer Wärmesenke, Kontaktieren eines Leistungshalbleiterelements auf der leitfähigen Struktur, flächiges Verbinden der Metalllage des Substrats über eine Lötverbindungsschicht mit einer metallischen Oberfläche einer Wärmesenke, wobei die nicht lötfähigen Beschichtung in einer Draufsicht außerhalb der Kontaktierungsfläche des zumindest einen Leistungshalbleiterelements aufgebracht wird.

Darüber hinaus wird die Aufgabe erfindungsgemäß durch ein Computerprogrammprodukt, umfassend Befehle, die bei einer Ausführung des Programms durch einen Computer diesen veranlassen, ein, insbesondere elektrisches, mechanisches und/oder thermisches, Verhalten einer derartigen Leistungshalbleiteranordnung zu simulieren.

Die in Bezug auf die Leistungshalbleiteranordnung nachstehend angeführten Vorteile und bevorzugten Ausgestaltungen lassen sich sinngemäß auf den Stromrichter, das Verfahren und das Computerprogrammprodukt übertragen.

Der Erfindung liegt die Überlegung zugrunde, durch gezieltes Einbringen zumindest einer Ausnehmung und/oder gezieltes Aufbringen von zumindest einer nicht lötfähigen Beschichtung in einem Bereich der Metalllage des Substrats, in welchem während des Betriebes der Leistungshalbleiteranordnung keine Wärme abzuführen ist, die Lage von sich beim Lötprozess der Systemlötung ausbildenden Hohlräumen zu steuern und so die Zuverlässigkeit des Wärmetransports zu optimieren. Abzuführende Wärme entsteht in der Leistungshalbleiteranordnung während des Betriebes in zumindest einem Leistungshalbleiterelement, welches beispielsweise als ein, insbesondere vertikaler, Transistor, beispielsweise als Insulated-Gate-Bipolar-Transistor (IGBT) ausgeführt sein kann. Derartige Bereiche befinden sich in einer Draufsicht, insbesondere vollständig, außerhalb einer Kontaktierungsfläche des zumindest einen Leistungshalbleiterelements, welches auf der der Metalllage gegenüberliegenden Seite des Substrats auf einer leitfähigen Struktur kontaktiert ist. Eine Draufsicht erfolgt in diesem Fall senkrecht auf die im Wesentlichen ebene Oberfläche der Metalllage des Substrats. Die leitfähige Struktur ist beispielsweise als strukturierte Kupfermetallisierung ausgeführt. Insbesondere ist das Substrat als DCB (Direct Copper Bonded) Substrat ausgeführt.

Alternativ kann die nicht lötfähige Beschichtung auf einer metallischen Oberfläche einer Wärmesenke, auf welcher die Metalllage des Substrats über eine Lötverbindungsschicht flächig verbunden wird, so aufgebracht werden, dass die nicht lötfähigen Beschichtung in einer Draufsicht, insbesondere vollständig, außerhalb der Kontaktierungsfläche des zumindest einen Leistungshalbleiterelements aufgebracht wird. Die Wärmesenke kann unter anderem als metallische Bodenplatte oder als Kühlkörper ausgeführt sein. Durch die zumindest eine Ausnehmung und/oder nicht lötfähige Beschichtung wird eine Benetzung auf der Metalllage des Substrats oder der Oberfläche der Bodenplatte gezielt dort gestört, wo sich auf der Oberseite kein Leistungshalbleiterelement befindet, sodass sich Hohlräume während des Abkühlens nach der Systemlötung an den gezielt angeordneten Störstellen ausbilden und der Wärmetransport von dem zumindest einen Leistungshalbleiterelement zur Wärmesenke optimiert wird. Die Optimierung des Wärmetransports hat eine verbesserte Performance und eine erhöhte Lebensdauer der Leistungshalbleiteranordnung zur Folge.

Ein Computerprogrammprodukt, welches Befehle umfasst, die bei einer Ausführung des Programms durch einen Computer diesen veranlassen, ein, insbesondere thermisches, mechanisches und oder elektrisches, Verhalten der beschriebenen Halbleiteranordnung zu simulieren kann einen "digitalen Zwilling", auch "digital twin" genannt, umfassen oder als ein solcher ausgebildet sein. Ein derartiger digitaler Zwilling ist beispielsweise in der wissenschaftlichen Publikation van der Valk, Hendrik et al: "Archetypes of Digital Twins" Business & Information Systems Engineering: Vol. 64: Iss. 3, 375-391 2022. Der Offenbarungsgehalt der wissenschaftlichen Publikation wird durch Verweisung in die vorliegende Anmeldung mit einbezogen. Der "digitale Zwilling" ist beispielsweise eine digitale Repräsentanz der für den Betrieb der Halbleiteranordnung relevanten Komponenten. Insbesondere verfügt das Computerprogramm über ein Physik-Modul, in dem die Leistungshalbleiteranordnung zumindest teilweise abgebildet wird und zumindest das thermische und mechanisches Verhalten von den abgebildeten Teilen des Halbleitermoduls unter einstellbaren Betriebsbedingungen und/oder Parametern, wie beispielsweise einer Anordnung der Leistungshalbleiterelemente und der Strukturierung des Substrats. Die abgebildeten Teile des Leistungshalbleiteranordnung können unter anderem eine Temperaturverteilung auf dem Substrat bzw. der Wärmesenke aufweisen, die im Wesentlichen einer Temperaturverteilung während des Vorgangs der Systemlötung entspricht. Unter Berücksichtigung zumindest der Löttemperatur, der Art und Größe des Substrats und des Schaltungslayouts kann in diesem Fall die thermo-mechanische Belastung ausgegeben werden.

Eine weitere Ausführungsform sieht vor, dass wobei die Metalllage des Substrats über eine Lötverbindungsschicht flächig mit einer metallischen Oberfläche einer Wärmesenke verbunden ist. Die Wärmesenke kann unter anderem als metallische Bodenplatte oder als Kühlkörper ausgeführt sein. Die Lötverbindungsschicht für die Systemlötung wird beispielsweise aus einer durchgängigen Lotschicht, welche insbesondere Zinn enthält, hergestellt. Die Lotschicht kann als Platte ausgeführt sein, die vor dem Erhitzen zwischen der Metalllage des Substrats und der metallischen Oberfläche einer Wärmesenke angeordnet wird. Beim Auftreten eines Unterdrucks beim Schmelzen wird Lot z.B. aus den Ausnehmungen gezogen und so der Unterdruck ausgeglichen. Eine unkontrollierte Ausbildung von Hohlräumen wird somit verhindert.

Eine weitere Ausführungsform sieht vor, dass die leitfähige Struktur zumindest ein erstes Leitermuster, auf welchem zumindest ein Leistungshalbleiterelement kontaktiert ist, und ein zweites Leitermuster aufweist, wobei die Leitermuster über ein Spaltmuster voneinander elektrisch isoliert angeordnet sind, wobei die zumindest eine Ausnehmung und/oder die zumindest eine nicht lötfähige Beschichtung in einer Draufsicht außerhalb des Spaltmusters angeordnet ist. Das Spaltmuster wird beispielsweise über Grabenätzungen hergestellt. Eine derartige Anordnung der zumindest einen Ausnehmung und/oder der zumindest einen nicht lötfähigen Beschichtung führt zu einer verbesserten Performance und Lebensdauer der Leistungshalbleiteranordnung.

Eine weitere Ausführungsform sieht vor, dass eine Ausnehmung zumindest abschnittsweise spaltartig ausgeführt ist. Beispielsweise ist eine Länge der Ausnehmung zehn Mal, insbesondere 20 Mal, größer als eine Breite der Ausnehmung. Insbesondere ist die Ausnehmung als gerader Spalt ausgeführt. Eine derartige Ausführung ist ausreichend für die Optimierung des Wärmetransports und gleichzeitig platzsparend. Durch eine derartige spaltartig ausgeführte Ausnehmung wird ein flexibles Layout ermöglicht.

Eine weitere Ausführungsform sieht vor, dass die spaltartige Ausnehmung eine Länge im Bereich von 5 mm bis 20 mm aufweist. Eine derartige Ausführung ist ausreichend für die Optimierung des Wärmetransports und gleichzeitig platzsparend.

Eine weitere Ausführungsform sieht vor, dass zumindest eine spaltartige Ausnehmung senkrecht zu einer angrenzenden Seitenkante des Substrats verlaufend angeordnet ist. Da Hohlräume bei der Systemlötung vorrangig im Randbereich auftreten wird durch eine Anordnung der Ausnehmung am Umfang bzw. äußeren Rand des Substrats ein besonders gutes Ergebnis erzielt. Der Bauraum kann besser ausgenutzt werden, was zu einer erhöhten Leistungsdichte führt.

Eine weitere Ausführungsform sieht vor, dass zumindest zwei spaltartige Ausnehmungen parallel zueinander angeordnet sind. Eine derartige Ausführung erzielt besonders gute Ergebnisse und ist gleichzeitig platzsparend

Eine weitere Ausführungsform sieht vor, dass die nicht lötfähige Beschichtung einen Lötstopplack, eine Graphitschicht oder eine Oxidschicht umfasst. Die Oxidschicht kann durch Anodisieren hergestellt sein. Derartige Beschichtungen sind kostengünstig herzustellen und lassen sich einfach in den vorhandenen Herstellungsprozess integrieren.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausführungsform einer Leistungshalbleiteranordnung in einer Draufsicht,
- FIG 2: eine schematische Darstellung einer zweiten Ausführungsform einer Leistungshalbleiteranordnung in einer Draufsicht,
- FIG 3: eine vergrößerte schematische Schnittdarstellung der zweiten Ausführungsform der Leistungshalbleiteranordnung in einer Seitenansicht,
- FIG 4: eine schematische Darstellung einer dritten Ausführungsform einer Leistungshalbleiteranordnung in einer Draufsicht,
- FIG 5: eine schematische Schnittdarstellung eines Verfahrens zur Herstellung der zweiten Ausführungsform der Leistungshalbleiteranordnung,
- FIG 6: eine schematische Schnittdarstellung eines Verfahrens zur Herstellung einer vierten Ausführungsform einer Leistungshalbleiteranordnung,
- FIG 7: eine schematische Schnittdarstellung eines Verfahrens zur Herstellung einer fünften Ausführungsform einer Leistungshalbleiteranordnung,
- FIG 8: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

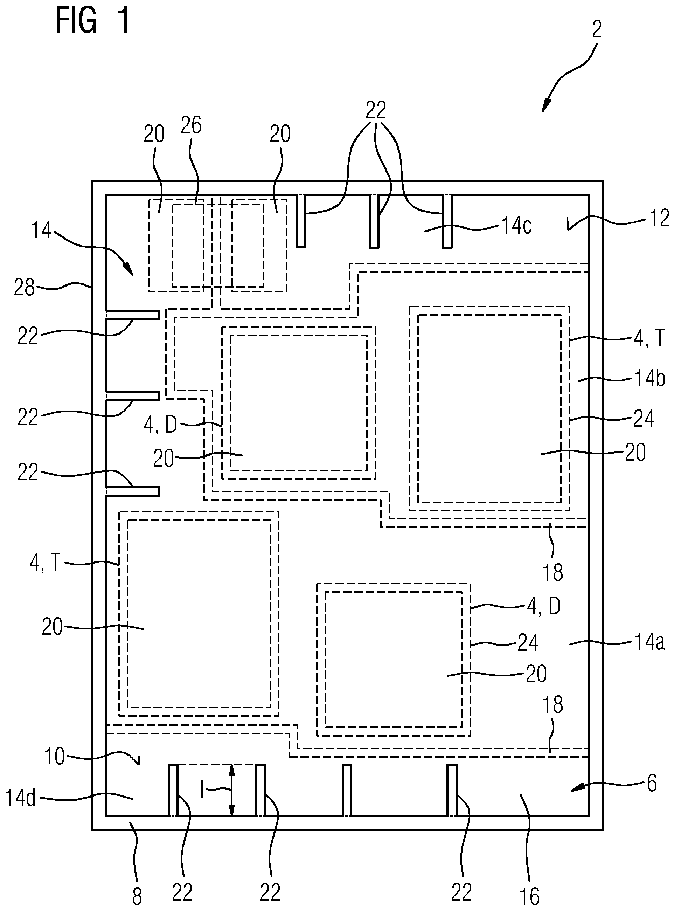

FIG 1 zeigt eine schematische Darstellung einer ersten Ausführungsform einer Leistungshalbleiteranordnung 2 in einer Draufsicht, welche Leistungshalbleiterelemente 4 umfasst, die auf einem, beispielhaft rechteckigen, Substrat 6 kontaktiert sind. Das Substrat 6 weist eine dielektrische Materiallage 8 mit einer ersten Oberfläche 10 und einer zweiten Oberfläche 12 auf, wobei die zweite Oberfläche 12 auf einer der ersten Oberfläche 10 abgewandten Seite der dielektrischen Materiallage 8 angeordnet ist. Die dielektrische Materiallage 8 unter anderem aus einem keramischen Werkstoff, beispielsweise Al2O3, AIN, Si3N4, hergestellt sein. Ferner weist das Substrat 6 eine leitfähige Struktur 14, welche auf der ersten Oberfläche 10 der dielektrische Materiallage 8 ausgebildet ist und eine Metalllage 16, welche auf der zweiten Oberfläche 12 der dielektrische Materiallage 8 angeordnet ist, auf. Die leitfähige Struktur 14 weist Leitermuster 14a, 14b, 14c, 14d auf, wobei die Leitermuster 14a, 14b, 14c, 14d über Spaltmuster 18 voneinander elektrisch isoliert angeordnet sind. Beispielsweise ist die leitfähige Struktur 14 als eine strukturierte Metallisierung, welche insbesondere Kupfer enthält, ausgeführt, wobei die Spaltmuster 18 durch Grabenätzungen realisiert sind.

Auf einem ersten und einem zweiten Leitermuster 14a, 14b sind jeweils zwei Leistungshalbleiterelemente 4 kontaktiert. Beispielhaft sind die Leistungshalbleiterelemente 4 jeweils als ein, insbesondere vertikaler, Transistor T, insbesondere als Insulated-Gate-Bipolar-Transistor (IGBT), und als eine, insbesondere antiparallel geschaltete, Diode D ausgeführt. Die Leistungshalbleiterelemente 4 weisen jeweils ein Kontaktierungspad 19 auf, über welches sie stoffschlüssig, insbesondere über eine Löt- oder Sinterverbindung, mit einer Kontaktierungsfläche 20 auf dem jeweiligen Leitermuster 14a, 14b der leitfähigen Struktur 14 des Substrats 6 verbunden sind.

Die Metalllage 16 des Substrats 6 weist eine Mehrzahl von Ausnehmungen 22 auf, welche in einer Draufsicht außerhalb der Kontaktierungsflächen 20 der Leistungshalbleiterelemente 4 und außerhalb der Spaltmuster 18 angeordnet sind. Ferner sind die Ausnehmungen 22 in einer Draufsicht außerhalb einer Außenkontur 24 der Leistungshalbleiterelemente 4 angeordnet. Die Ausnehmungen 22 können unter anderem durch einen Ätzprozess oder durch Fräsen eingebracht werden. Zwischen dem ersten und einem dritten Leitermuster 14a, 14c ist ein passives Bauelement 26, welches beispielhaft als Shunt-Widerstand ausgeführt ist, angeordnet, wobei die Ausnehmungen 22 in einer Draufsicht außerhalb der Kontaktierungsflächen 20 des passives Bauelements 26 angeordnet sind. Die Ausnehmungen 22 sind rechteckig spaltartig ausgeführt und verlaufen senkrecht zu einer angrenzenden Seitenkante 28 des rechteckigen Substrats 6. Alternativ können die Ausnehmungen 22 unter anderem trapezförmig oder dreieckig ausgeführt sein. Die jeweils senkrecht von einer angrenzenden Seitenkante 28 des rechteckigen Substrats 6 weglaufenden Ausnehmungen 22 sind parallel zueinander angeordnet und weisen dieselbe Länge I, z.B. im Bereich von 5 mm bis 20 mm, auf.

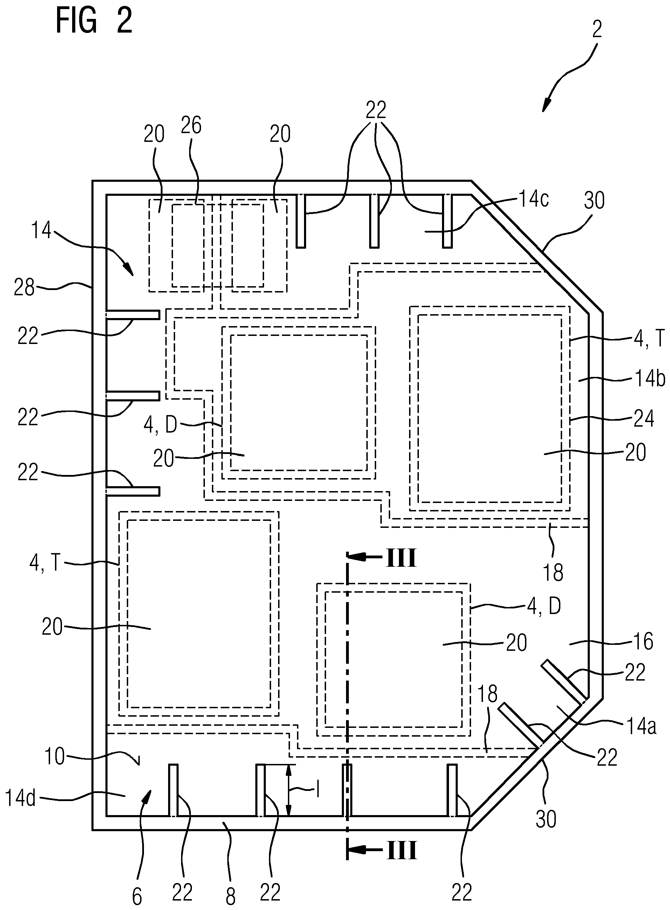

FIG 2 zeigt eine schematische Darstellung einer zweiten Ausführungsform einer Leistungshalbleiteranordnung 2 in einer Draufsicht, wobei das Substrat 6 durch Eckabschrägungen 30 sechseckig ausgeführt ist. Die Ausnehmungen 22 verlaufen auch im Bereich der Eckabschrägungen 30 senkrecht zur jeweiligen Seitenkante 28 des Substrats 6. Die weitere Ausführung der Halbleiteranordnung 2 in FIG 2 entspricht der in FIG 1.

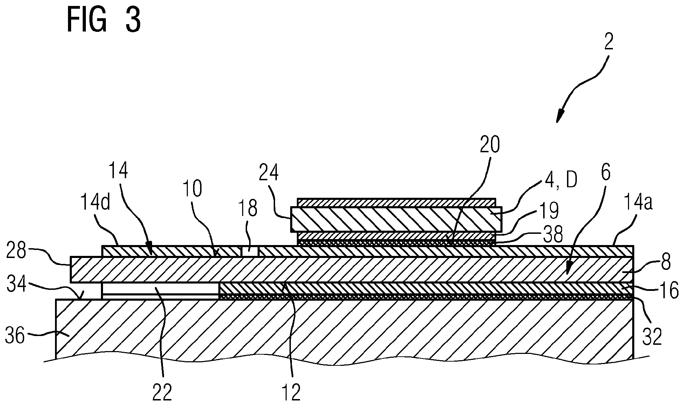

FIG 3 zeigt eine vergrößerte schematische Schnittdarstellung der zweiten Ausführungsform der Leistungshalbleiteranordnung 2 in einer Seitenansicht, wobei die Metalllage 16 des Substrats 6 über eine Lötverbindungsschicht 32 flächig mit einer metallischen Oberfläche 34 einer Wärmesenke 36 verbunden ist. Die Wärmesenke 36 kann unter anderem als metallische Bodenplatte oder als Kühlkörper ausgeführt sein. Das Kontaktierungspad 19 des Leistungshalbleiterelements 4 ist über eine Löt- oder Sinterverbindung 38 stoffschlüssig mit der Kontaktierungsfläche 20 der leitfähigen Struktur 14 des Substrats 6 verbunden. Die Herstellung einer Lotverbindung zwischen dem Substrat 6 und der Wärmesenke 36 mittels der Lötverbindungsschicht 32 wird Systemlötung genannt. Durch das gezielte Einbringen von Ausnehmungen 22 wird in Bereichen des Substrats 6 in welchen während eines Betriebes der Leistungshalbleiteranordnung 2 abzuführende Abwärme entsteht, insbesondere im Bereich der Leistungshalbleiterelemente 4, die Ausbildung von Hohlräumen, sog. "Lunkern", verhindert, sodass ein zuverlässiger Wärmetransport zur Wärmesenke 36 erreicht wird. Da die Hohlräume vorrangig im Randbereich auftreten, können durch, insbesondere senkrecht, von einer angrenzenden Seitenkante 28 des rechteckigen Substrats 6 weglaufenden Ausnehmungen 22 Leistungshalbleiterelemente 4 weiter im Randbereich platziert werden, wodurch der verfügbare Bauraum besser ausgenutzt wird, was zu einer Erhöhung der Leistungsdichte und einer Verringerung der Kosten führt. Die weitere Ausführung der Halbleiteranordnung 2 in FIG 3 entspricht der in FIG 2.

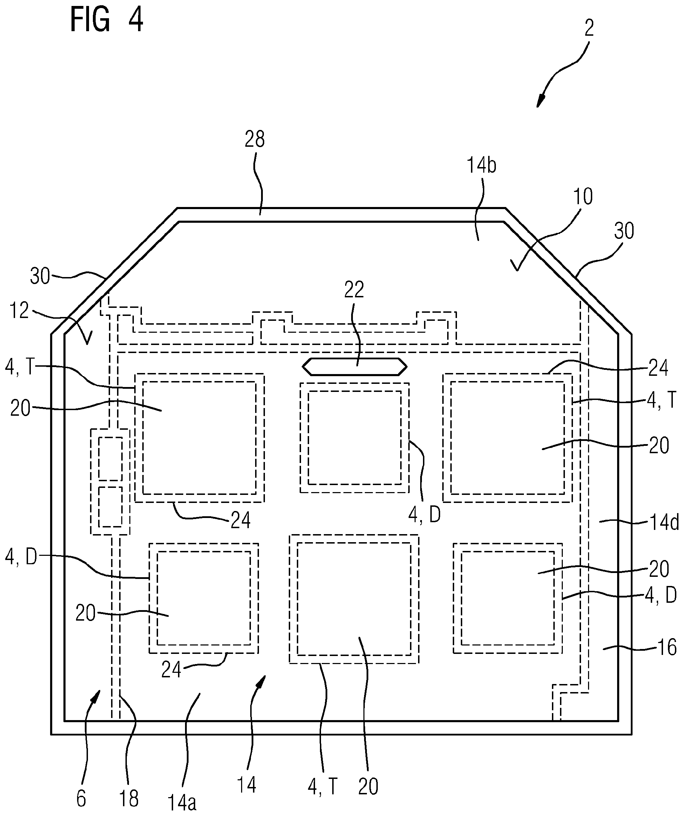

FIG 4 zeigt eine schematische Darstellung einer dritten Ausführungsform einer Leistungshalbleiteranordnung 2 in einer Draufsicht, Die Metalllage 16 des Substrats 6 weist eine Ausnehmung 22 in der Nähe eines Leistungshalbleiterelements 4 auf, welche in einer Draufsicht außerhalb der Kontaktierungsflächen 20 der Leistungshalbleiterelemente 4 und außerhalb der Spaltmuster 18 angeordnet ist. Ferner ist die Ausnehmung 22 in einer Draufsicht außerhalb einer Außenkontur 24 der Leistungshalbleiterelemente 4 angeordnet. Die spaltartige Ausnehmung 22 ist in FIG 4 nicht im Randbereich, sondern in einem mittleren Bereich des Substrats 6 angeordnet und verläuft parallel zur nächsten Seitenkante 28 und zur nächsten Kante einer Kontaktierungsfläche 20. Die weitere Ausführung der Halbleiteranordnung 2 in FIG 4 entspricht der in FIG 2.

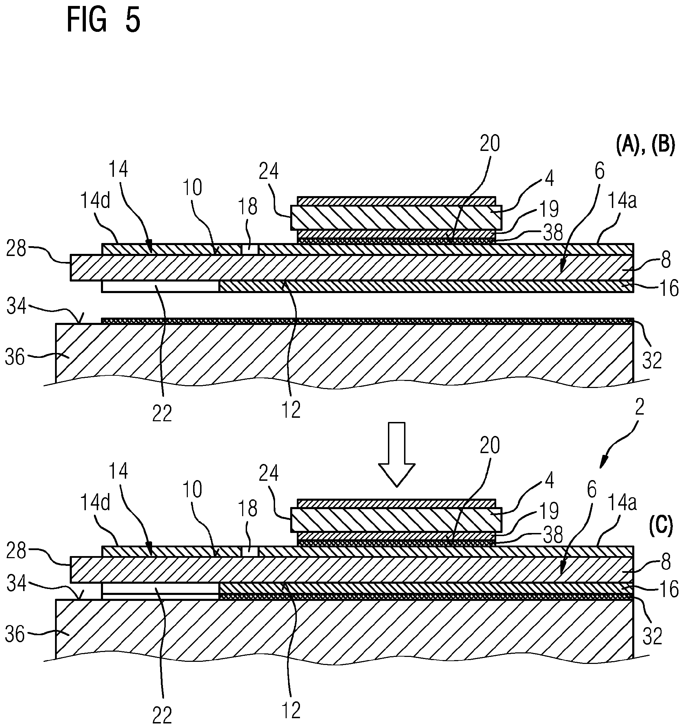

FIG 5 zeigt eine schematische Schnittdarstellung eines Verfahrens zur Herstellung der zweiten Ausführungsform der Leistungshalbleiteranordnung 2, wobei ein Einbringen A der Ausnehmungen 22 in die die Metalllage 16 erfolgt. Das Einbringen A der Ausnehmungen 22 kann unter anderem durch Ätzen oder durch Fräsen erfolgen. In einem weiteren Schritt erfolgt ein Kontaktieren B der Leistungshalbleiterelemente 4 auf der leitfähigen Struktur 14. Das Kontaktieren kann beispielsweise ein stoffschlüssiges Verbinden der Kontaktierungspads 19 der Leistungshalbleiterelemente 4 über eine Löt- oder Sinterverbindung 38 mit der Kontaktierungsfläche 20 der leitfähigen Struktur 14 des Substrats 6 umfassen. In einem weiteren Schritt erfolgt ein flächiges Verbinden C der Metalllage 16 des Substrats 6 über eine Lötverbindungsschicht 32 mit einer metallischen Oberfläche 34 einer Wärmesenke 36, wobei die Ausnehmung 22 in einer Draufsicht außerhalb der Kontaktierungsfläche 20 des zumindest einen Leistungshalbleiterelements 4 und außerhalb des Spaltmusters 18 eingebracht wird. Die Lötverbindungsschicht 32 für die Systemlötung wird beispielsweise aus einer durchgängigen Lotschicht, welche insbesondere Zinn enthält, hergestellt. Die Lotschicht kann als Platte ausgeführt sein, die vor dem Erhitzen zwischen der Metalllage 16 des Substrats 6 und der metallischen Oberfläche 34 der Wärmesenke 36 angeordnet wird. Beim Auftreten eines Unterdrucks beim Schmelzen wird Lot z.B. aus den Ausnehmungen 22 gezogen und so der Unterdruck ausgeglichen. Die unkontrollierte Ausbildung von Hohlräumen, insbesondere unterhalb der Leistungshalbleiterelemente 4, wird verhindert. Die weitere Ausführung der Halbleiteranordnung 2 in FIG 5 entspricht der in FIG 2.

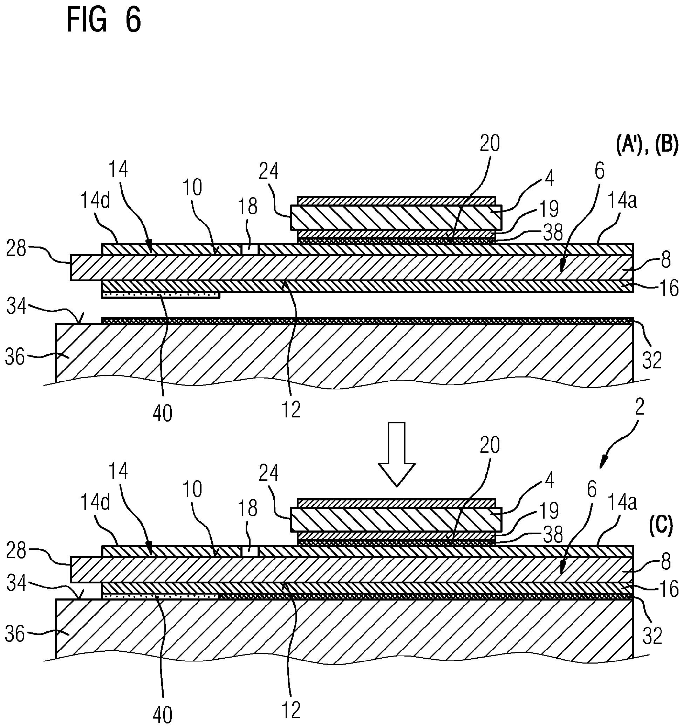

FIG 6 zeigt eine schematische Schnittdarstellung eines Verfahrens zur Herstellung einer vierten Ausführungsform einer Leistungshalbleiteranordnung 2. Das Verfahren umfasst ein Aufbringen A` zumindest einer nicht lötfähigen Beschichtung 40 auf die Metalllage 16 des Substrats 6, wobei die nicht lötfähigen Beschichtung 40 in einer Draufsicht außerhalb der Kontaktierungsfläche 20 des zumindest einen Leistungshalbleiterelements 4 und außerhalb des Spaltmusters 18 aufgebracht wird. Die nicht lötfähige Beschichtung 40 kann unter anderem einen Lötstopplack, eine Graphitschicht oder eine Oxidschicht umfassen, wobei die Oxidschicht durch Anodisieren hergestellt sein kann. Die weitere Ausgestaltung des Verfahrens in FIG 6 entspricht der in FIG 5.

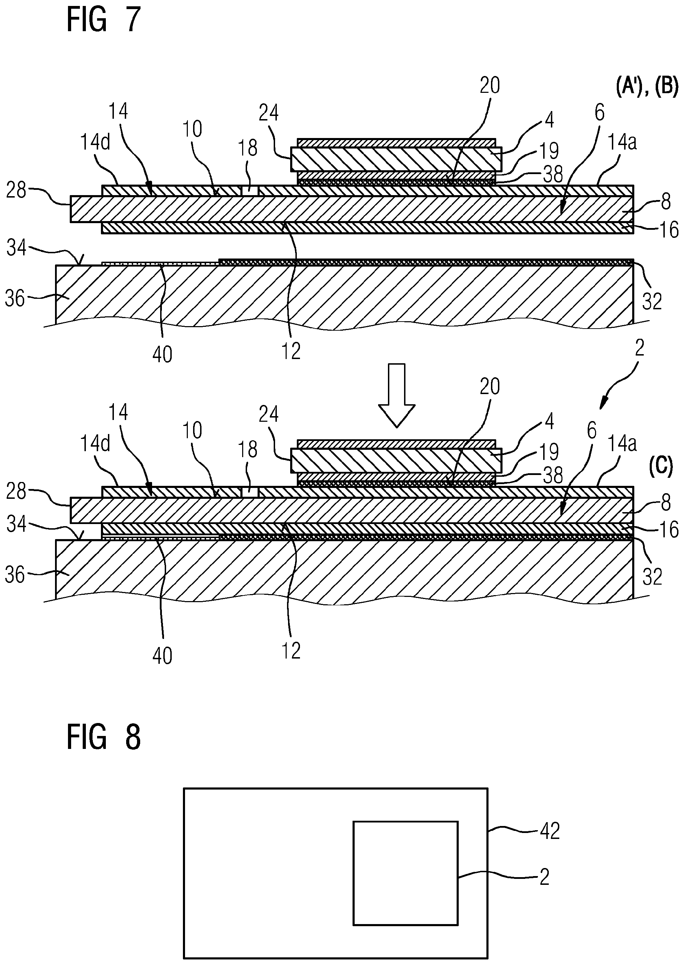

FIG 7 zeigt eine schematische Schnittdarstellung eines Verfahrens zur Herstellung einer fünften Ausführungsform einer Leistungshalbleiteranordnung 2. Das Verfahren umfasst ein Aufbringen A` zumindest einer nicht lötfähigen Beschichtung 40 auf die metallische Oberfläche 34 der Wärmesenke 36, wobei die nicht lötfähigen Beschichtung 40 in einer Draufsicht außerhalb der Kontaktierungsfläche 20 des zumindest einen Leistungshalbleiterelements 4 und außerhalb des Spaltmusters 18 aufgebracht wird. Die weitere Ausgestaltung des Verfahrens in FIG 7 entspricht der in FIG 6.

FIG 8 zeigt eine schematische Darstellung eines Stromrichters 42, welcher beispielhaft eine Leistungshalbleiteranordnung 2 umfasst.

Zusammenfassend betrifft die Erfindung eine Leistungshalbleiteranordnung 2 aufweisend zumindest ein Leistungshalbleiterelement 4, ein Substrat 6 aufweisend eine dielektrische Materiallage 8 mit einer ersten Oberfläche 10 und einer zweiten Oberfläche 12, welche auf einer der ersten Oberfläche 10 abgewandten Seite der dielektrischen Materiallage 8 angeordnet ist, eine leitfähige Struktur 14, welche auf der ersten Oberfläche 10 der dielektrische Materiallage 8 ausgebildet ist und auf welcher das zumindest eine Leistungshalbleiterelement 4 kontaktiert ist, und eine Metalllage 16, welche auf der zweiten Oberfläche 12 der dielektrische Materiallage 8 angeordnet ist. Um die Performance und Zuverlässigkeit einer Leistungshalbleiteranordnung zu verbessern, wird vorgeschlagen, dass die Metalllage 16 zumindest eine Ausnehmung 22 und/oder zumindest eine nicht lötfähige Beschichtung 40 aufweist, welche in einer Draufsicht außerhalb einer Kontaktierungsfläche 20 des zumindest einen Leistungshalbleiterelements 4 angeordnet ist.

## Patentansprüche

1. Leistungshalbleiteranordnung (2) aufweisend:
- zumindest ein Leistungshalbleiterelement (4),
- ein Substrat (6) aufweisend
- eine dielektrische Materiallage (8) mit einer ersten Oberfläche (10) und einer zweiten Oberfläche (12), welche auf einer der ersten Oberfläche (10) abgewandten Seite der dielektrischen Materiallage (8) angeordnet ist,
- eine leitfähige Struktur (14), welche auf der ersten Oberfläche (10) der dielektrische Materiallage (8) ausgebildet ist und auf welcher das zumindest eine Leistungshalbleiterelement (4) kontaktiert ist, und
- eine Metalllage (16), welche auf der zweiten Oberfläche (12) der dielektrische Materiallage (8) angeordnet ist,
**dadurch gekennzeichnet, dass**
die Metalllage (16) zumindest eine Ausnehmung (22) und/oder zumindest eine nicht lötfähige Beschichtung (40) aufweist, welche in einer Draufsicht außerhalb einer Kontaktierungsfläche (20) des zumindest einen Leistungshalbleiterelements (4) angeordnet ist.

2. Leistungshalbleiteranordnung (2) nach Anspruch 1,
wobei die Metalllage (16) des Substrats (6) über eine Lötverbindungsschicht (32) flächig mit einer metallischen Oberfläche (34) einer Wärmesenke (36) verbunden ist.

3. Leistungshalbleiteranordnung (2) nach einem der Ansprüche 1 oder 2,
wobei die leitfähige Struktur (14) zumindest ein erstes Leitermuster (14a), auf welchem zumindest ein Leistungshalbleiterelement (4) kontaktiert ist, und ein zweites Leitermuster (14b) aufweist,
wobei die Leitermuster (14a, 14b) über ein Spaltmuster (18) voneinander elektrisch isoliert angeordnet sind,
wobei die zumindest eine Ausnehmung (22) und/oder die zumindest eine nicht lötfähige Beschichtung (40) in einer Draufsicht außerhalb des Spaltmusters (18) angeordnet ist.

4. Leistungshalbleiteranordnung (2) nach einem der vorherigen Ansprüche,
wobei eine Ausnehmung (22) zumindest abschnittsweise spaltartig ausgeführt ist.

5. Leistungshalbleiteranordnung (2) nach Anspruch 4,
wobei die spaltartige Ausnehmung (22) eine Länge (I) im Bereich von 5 mm bis 20 mm aufweist.

6. Leistungshalbleiteranordnung (2) nach einem der Ansprüche 4 oder 5,
wobei zumindest eine spaltartige Ausnehmung (22) senkrecht zu einer angrenzenden Seitenkante (28) des Substrats (6) verlaufend angeordnet ist.

7. Leistungshalbleiteranordnung (2) nach einem der Ansprüche 4 bis 6,
wobei zumindest zwei spaltartige Ausnehmungen (22) parallel zueinander angeordnet sind.

8. Leistungshalbleiteranordnung (2) nach einem der vorherigen Ansprüche,
wobei die nicht lötfähige Beschichtung (40) einen Lötstopplack, eine Graphitschicht oder eine Oxidschicht umfasst.

9. Leistungshalbleiteranordnung (2), aufweisend:
- zumindest ein Leistungshalbleiterelement (4),
- ein Substrat (6) aufweisend
- eine dielektrische Materiallage (8) mit einer ersten Oberfläche (10) und einer zweiten Oberfläche (12), welche auf einer der ersten Oberfläche (10) abgewandten Seite der dielektrischen Materiallage (8) angeordnet ist,
- eine leitfähige Struktur (14), welche auf der ersten Oberfläche (10) der dielektrische Materiallage (8) ausgebildet ist und auf welcher das zumindest eine Leistungshalbleiterelement (4) kontaktiert ist, und
- eine Metalllage (16), welche auf der zweiten Oberfläche (12) der dielektrische Materiallage (8) angeordnet ist,
**dadurch gekennzeichnet, dass**
wobei die Metalllage (16) des Substrats (6) über eine Lötverbindungsschicht (32) flächig mit einer metallischen Oberfläche (34) einer Wärmesenke (36) verbunden ist,
wobei die metallische Oberfläche (34) der Wärmesenke (36) zumindest eine nicht lötfähige Beschichtung (40) aufweist, welche in einer Draufsicht außerhalb einer Kontaktierungsfläche (20) des zumindest einen Leistungshalbleiterelements (4) angeordnet ist.

10. Stromrichter (42) mit mindestens einer Leistungshalbleiteranordnung (2) nach einem der vorherigen Ansprüche.

11. Verfahren zur Herstellung einer Leistungshalbleiteranordnung (2) mit einem Substrat (6) aufweisend eine dielektrische Materiallage (8) mit einer ersten Oberfläche (10) und einer zweiten Oberfläche (12), welche auf einer der ersten Oberfläche (10) abgewandten Seite der dielektrischen Materiallage (8) angeordnet ist,
wobei eine leitfähige Struktur (14) auf der ersten Oberfläche (10) der dielektrischen Materiallage (8) ausgebildet ist,
wobei eine Metalllage (16) auf der zweiten Oberfläche (12) der dielektrischen Materiallage (8) angeordnet ist,
aufweisend folgende Schritte:
▪ Einbringen (A) zumindest einer Ausnehmung (22) in die die Metalllage (16),
▪ Kontaktieren (B) eines Leistungshalbleiterelements (4) auf der leitfähigen Struktur (14),
▪ flächiges Verbinden (C) der Metalllage (16) des Substrats (6) über eine Lötverbindungsschicht (32) mit einer metallischen Oberfläche (34) einer Wärmesenke (36),
wobei die Ausnehmung (22) in einer Draufsicht außerhalb der Kontaktierungsfläche (20) des zumindest einen Leistungshalbleiterelements (4) angeordnet wird.

12. Verfahren nach Anspruch 11,
wobei die leitfähige Struktur (14) zumindest ein erstes Leitermuster (14a), auf welchem zumindest ein Leistungshalbleiterelement (4) kontaktiert wird, und ein zweites Leitermuster (14b) aufweist,
wobei die Leitermuster (14a, 14b) über ein Spaltmuster (18) voneinander elektrisch isoliert angeordnet sind,
wobei die zumindest eine Ausnehmung (22) in einer Draufsicht außerhalb des Spaltmusters (18) eingebracht wird.

13. Verfahren zur Herstellung einer Leistungshalbleiteranordnung (2) mit einem Substrat (6) aufweisend eine dielektrische Materiallage (8) mit einer ersten Oberfläche (10) und einer zweiten Oberfläche (12), welche auf einer der ersten Oberfläche (10) abgewandten Seite der dielektrischen Materiallage (8) angeordnet ist,
wobei eine leitfähige Struktur (14) auf der ersten Oberfläche (10) der dielektrischen Materiallage (8) ausgebildet ist,
wobei eine Metalllage (16) auf der zweiten Oberfläche (12) der dielektrischen Materiallage (8) angeordnet ist,
aufweisend folgende Schritte:
▪ Aufbringen (A`) zumindest einer nicht lötfähigen Beschichtung (40) auf die Metalllage (16),
▪ Kontaktieren (B) eines Leistungshalbleiterelements (4) auf der leitfähigen Struktur (14),
▪ flächiges Verbinden (C) der Metalllage (16) des Substrats (6) über eine Lötverbindungsschicht (32) mit einer metallischen Oberfläche (34) einer Wärmesenke (36),
wobei die nicht lötfähigen Beschichtung (40) in einer Draufsicht außerhalb der Kontaktierungsfläche (20) des zumindest einen Leistungshalbleiterelements (4) aufgebracht wird.

14. Verfahren zur Herstellung einer Leistungshalbleiteranordnung (2) mit einem Substrat (6) aufweisend eine dielektrische Materiallage (8) mit einer ersten Oberfläche (10) und einer zweiten Oberfläche (12), welche auf einer der ersten Oberfläche (10) abgewandten Seite der dielektrischen Materiallage (8) angeordnet ist,
wobei eine leitfähige Struktur (14) auf der ersten Oberfläche (10) der dielektrischen Materiallage (8) ausgebildet ist,
wobei eine Metalllage (16) auf der zweiten Oberfläche (12) der dielektrischen Materiallage (8) angeordnet ist,
aufweisend folgende Schritte:
▪ Aufbringen (A`) zumindest einer nicht lötfähigen Beschichtung (40) auf eine metallische Oberfläche (34) einer Wärmesenke (36),
▪ Kontaktieren (B) eines Leistungshalbleiterelements (4) auf der leitfähigen Struktur (14),
▪ flächiges Verbinden (C) der Metalllage (16) des Substrats (6) über eine Lötverbindungsschicht (32) mit einer metallischen Oberfläche (34) einer Wärmesenke (36),
wobei die nicht lötfähigen Beschichtung (40) in einer Draufsicht außerhalb der Kontaktierungsfläche (20) des zumindest einen Leistungshalbleiterelements (4) aufgebracht wird.

15. Verfahren nach einem der Ansprüche 13 oder 14,
wobei die leitfähige Struktur (14) zumindest ein erstes Leitermuster (14a), auf welchem zumindest ein Leistungshalbleiterelement (4) kontaktiert wird, und ein zweites Leitermuster (14b) aufweist,
wobei die Leitermuster (14a, 14b) über ein Spaltmuster (18) voneinander elektrisch isoliert angeordnet sind,
wobei die zumindest eine nicht lötfähige Beschichtung (40) in einer Draufsicht außerhalb des Spaltmusters (18) aufgebracht wird.

16. Computerprogrammprodukt, umfassend Befehle, die bei einer Ausführung des Programms durch einen Computer diesen veranlassen, ein, insbesondere elektrisches, mechanisches und/oder thermisches, Verhalten einer Leistungshalbleiteranordnung (2) nach einem der Ansprüche 1 bis 9 zu simulieren.
